# EUROPÄISCHE PATENTSCHRIFT

(11) **EP 0 933 388 B1**
(45) Veröffentlichungstag und Bekanntmachung des Hinweises auf die Patenterteilung: **16.10.2002**
(21) Anmeldenummer: 98124383.5
(22) Anmeldetag: 21.12.1998
(51) Int. Cl.: C08J 7/00, C08J 7/16, C08J 7/18, B29C 59/02, B44C 1/24

(54) **Strukturierte Oberflächen mit hydrophoben Eigenschaften**
Structured surfaces having hydrophobic properties
Surfaces structurelles avec propriétés hydrophobes

(30) Priorität: 30.01.1998 DE 19803787
(43) Veröffentlichungstag der Anmeldung: 04.08.1999
(73) Patentinhaber: CREAVIS Gesellschaft für Technologie und Innovation mbH, 45764 Marl (DE)
(72) Erfinder: Schleich, Bernhard Dr., 45657 Recklinghausen (DE); Peters, Ralf-Peter Dr., 51467 Bergisch Gladbach (DE)
(74) Vertreter: Olbricht, Gerhard, Dr.

(56) Entgegenhaltungen:
- EP-A1- 0 659 590
- EP-A1- 0 693 371
- WO-A1-96/04123

## Beschreibung

Die vorliegende Erfindung betrifft strukturierte Oberflächen aus einem Material mit einer geringen Oberflächenenergie.

Weiterhin betrifft die vorliegende Erfindung Verfahren zur Herstellung dieser strukturierten Oberflächen und die Verwendung der strukturierten Oberflächen zur Herstellung von schwer benetzbaren Gegenständen.

Gegenstände mit schwer benetzbaren Oberflächen weisen eine Reihe von interessanten und wirtschaftlich wichtigen Merkmalen auf. So sind sie leicht zu reinigen und bieten Rückständen wenig Halt. Diese Eigenschaften betreffen insbesondere transparente und ästhetisch ansprechende Gegenstände.

Oberflächen, von denen Wasser leicht abläuft, müssen entweder sehr hydrophil oder hydrophob sein. Hydrophile Oberflächen besitzen geringe Kontaktwinkel mit Wasser; dies bewirkt eine rasche Verteilung des Wassers auf der Oberfläche und schließlich ein schnelles Ablaufen des so entstandenen Wasserfilms von der Oberfläche.

Hydrophobe Oberflächen dagegen sorgen mittels eines großen Kontaktwinkels mit Wasser für eine Tropfenbildung. Diese Tropfen können auf geneigten Oberflächen schnell abrollen.

Der Einsatz von hydrophoben Materialien wie perfluorierte Polymere zur Herstellung von hydrophoben Oberflächen ist bekannt; eine Weiterentwicklung dieser Oberflächen besteht darin, die Oberflächen im µm bis nm-Bereich zu strukturieren.

US-PS 55 99 489 offenbart ein Verfahren, bei dem eine Oberfläche durch Beschuß mit Partikeln einer entsprechenden Größe und anschließender Perfluorierung besonders wasserabweisend ausgestattet werden kann.

Ein anderes Verfahren beschreiben H. Saito et al. in Surface Coating International 4, 1997, S. 168 ff. Hier werden Partikel aus Fluorpolymeren auf Metalloberflächen aufgebracht, wobei eine stark erniedrigte Benetzbarkeit der so erzeugten Oberflächen gegenüber Wasser und eine erheblich reduzierte Vereisungsneigung festgestellt wurde.

In US-PS 33 54 022 und WO 96/04123 sind weitere Verfahren zur Erniedrigung der Benetzbarkeit von Gegenständen durch topologische Veränderungen der Oberflächen beschrieben. Hier werden künstliche Erhebungen bzw. Vertiefungen mit einer Höhe von ca. 5 bis 1000 µm und einem Abstand von ca. 5 bis 500 µm auf hydrophobe oder nach der Strukturierung hydrophobierte Werkstoffe aufgebracht. Oberflächen dieser Art führen zu einer schnellen Tropfenbildung, wobei die abrollenden Tropfen Schmutzteilchen aufnehmen und somit die Oberfläche reinigen. Angaben über ein Aspektverhältnis der Erhebungen sind nicht vorhanden.

Oberflächen dieser Art besitzen einen hohen Kontakt- oder Randwinkel mit Wasser, werden jedoch von Flüssigkeiten wie Öl vollständig benetzt. Einmal benetzt, ist auch der durch die Struktur gegebene Effekt des hohen Kontaktwinkels mit Wasser verloren. Die Anwendung solcher Materialien ist also auf Gebiete beschränkt, wo keine ölfilmbildenden Flüssigkeiten (z. B. im Straßenverkehr) vorkommen.

Der vorliegenden Erfindung lag daher die Aufgabe zugrunde, technische Oberflächen zu entwickeln, die gegenüber Wasser einen sehr hohen Randwinkel aufweisen und von Verschmutzungen, insbesondere von öligen Verschmutzungen, z. B. durch Abspülen mit Wasser gereinigt werden können oder die das Ablaufen von Wasser begünstigen.

Es wurde überraschenderweise gefunden, daß strukturierte Oberflächen mit Erhebungen einer Höhe von 50 nm bis 10 µm und einem mittleren Abstand von 50 nm bis 10 µm sowie einer Oberflächenenergie des unstrukturierten Materials von 10 bis 20 mN/m von Wasser nahezu nicht benetzt werden und auch von öligen Verschmutzungen leicht zu reinigen sind.

Gegenstand der vorliegenden Erfindung sind daher strukturierte Oberflächen mit Erhebungen einer Höhe von 50 nm bis 10 µm und einem mittleren Abstand von 50 nm bis 10 µm sowie Oberflächenenergien des unstrukturierten Materials von 10 bis 20 mN/m.

Weiterhin ist Gegenstand der vorliegenden Erfindung ein Verfahren zur Herstellung von strukturierten Oberflächen, wobei Erhebungen auf einen Werkstoff mit einer Oberflächenenergie von 10 bis 20 mN/m mechanisch eingeprägt oder durch lithographische Verfahren eingeätzt oder durch formgebundene Verarbeitung aufgebracht werden.

Werkstoffe im Sinne der vorliegenden Erfindung sind Produkte, die bereits ihre endgültige Verwendungsform besitzen, Halbzeuge oder Vorprodukte wie z. B. Granulate oder Pulver, die noch einen formgebenden Prozeß wie z. B. Schmelzen, Gießen oder Extrudieren durchlaufen müssen:

Außerdem ist Gegenstand der vorliegenden Erfindung die Verwendung der strukturierten Oberflächen zur Herstellung von mit polaren oder unpolaren Flüssigkeiten nicht oder nur schwer benetzbaren Erzeugnissen.

Erfindungsgemäß strukturierte Oberflächen weisen besonders hohe Randwinkel auf. Dies verhindert weitgehend die Benetzung der Oberfläche und führt zu einer raschen Tropfenbildung. Die Tropfen können bei entsprechender Neigung der Oberfläche auf den Erhebungen abrollen, nehmen hierbei Schutzpartikel auf und reinigen somit gleichzeitig die Oberfläche.

Oberflächen im Sinne der vorliegenden Erfindung sind nicht nur hydrophob, sondern auch oleophob. Diese Eigenschaft erweitert die Anwendungsbereiche der strukturierten Oberflächen auch auf Gebiete, wo mit ölhaltigen Flüssigkeiten oder Verschmutzungen zu rechnen ist, so z. B. Straßen-, Bahn- und Flugverkehr sowie in industriellen Fertigungsanlagen.

Gegenstände mit erfindungsgemäß strukturierten Oberflächen sind sehr leicht zu reinigen. Sofern abrollende Tropfen von z. B. Regenwasser, Tau oder sonstigem, im Einsatzbereich des Gegenstandes vorkommenden Wasser zur Reinigung nicht ausreichen, können die Gegenstände durch einfaches Abspülen mit Wasser gereinigt werden.

Bakterien und andere Mikroorganismen benötigen zur Adhäsion an eine Oberfläche oder zur Vermehrung an einer Oberfläche Wasser, welches an den hydrophoben Oberflächen der vorliegenden Erfindung nicht zur Verfügung steht. Erfindungsgemäß strukturierte Oberflächen verhindern das Anwachsen von Bakterien und anderen Mikroorganismen und sind somit bakteriophob und/oder antimikrobiell.

Die Charakterisierung von Oberflächen bezüglich ihrer Benetzbarkeit kann über die Messung der Oberflächenenergie erfolgen. Diese Größe ist z. B. über die Messung der Randwinkel am glatten Material von verschiedenen Flüssigkeiten zugänglich (D.K. Owens, R. C. Wendt, J. Appl. Polym. Sci. 13, 1741(1969)) und wird in mN/m (Milli-Newton pro Meter) angegeben. Nach Owens et al. bestimmt, weisen glatte Polytetrafluorethylen-Oberflächen eine Oberflächenenergie von 19.1 mN/m auf, wobei der Randwinkel mit Wasser 110 ° beträgt. Allgemein besitzen hydrophobe Materialien mit Wasser Kontakt- oder Randwinkel von über 90 °.

Die Bestimmung des Randwinkels bzw. der Oberflächenenergie erfolgt zweckmäßig an glatten Oberflächen, um eine bessere Vergleichbarkeit zu gewährleisten. Die Materialeigenschaft "Hydrophobie" wird durch die chemische Zusammensetzung der obersten Molekülschicht der Oberfläche bestimmt. Ein höherer Randwinkel bzw. niedrigere Oberflächenenergie eines Materials kann daher auch durch Beschichtungsverfahren erreicht werden.

Erfindungsgemäße Oberflächen weisen höhere Randwinkel als die entsprechenden glatten Materialien auf (siehe Beispiel). Der makroskopisch beobachtete Randwinkel ist somit eine Oberflächeneigenschaft, welche die Materialeigenschaften plus die Oberflächenstruktur wiederspiegelt.

Eine besonders niedrige Oberflächenenergie ist insbesondere dann notwendig, wenn nicht nur hydrophobes, sondern auch oleophobes Verhalten gefordert ist. Dies ist insbesondere bei nichtfesten, öligen Verschmutzungen der Fall. Diese führen nämlich bei nicht-oleophoben Oberflächen zu einer Benetzung mit Öl, was die genannten Eigenschaften nachhaltig negativ beeinflußt. Für solche Anwendungen sollte die Oberflächenenergie der glatten, nichtstrukturierten Oberflächen unterhalb von 20 m/Nm, vorzugsweise bei 10 bis 20 mN/m liegen.

Die Oberflächeneigenschaften der erfindungsgemäßen Oberflächen sind von der Höhe, der Form und dem Abstand der Erhebungen abhängig. Bewährt haben sich Erhebungen mit einer mittleren Höhe von 50 nm bis 10 µm und einem mittleren Abstand von 50 nm bis 10 µm.

Bevorzugt liegt daher die mittlere Höhe der Erhebungen bei 50 nm bis 4 µm bei einem mittleren Abstand von 50 nm bis 10 µm. Alternativ kann die mittlere Höhe der Erhebungen 50 nm bis 10 µm bei einem mittleren Abstand von 50 nm bis 4 µm betragen. Besonders bevorzugt besitzen die Erhebungen eine Höhe von 50 nm bis 4 µm bei einem mittleren Abstand von 50 nm bis 4 µm.

Das Verhältnis von Höhe zu Breite der Erhebungen, das Aspektverhältnis, ist ebenfalls von Bedeutung. Die Erhebungen weisen bevorzugt ein Aspektverhältnis von 0,5 bis 20, besonders bevorzugt von 1 bis 10, ganz besonders bevorzugt von 1 bis 3.0 auf.

Um die aufgabengemäßen, niedrigen Randwinkel zu erreichen, sind neben den strukturellen auch die chemischen Eigenschaften des Materials von Bedeutung. Hier ist insbesondere die chemische Zusammensetzung der obersten Monolage des Materials entscheidend.

Erfindungsgemäße Oberflächen können daher aus Materialien hergestellt werden, die bereits vor der Strukturierung ihrer Oberfläche hydrophobes Verhalten aufweisen. Diese Werkstoffe beinhalten insbesondere Bulkpolymere mit Polytetrafluorethylen, Polyvinylidenfluorid oder Polymere aus Perfluoralkyoxyverbindungen, sei es als Homo- oder Copolymer oder als Mischungsbestandteil eines Polymerblends.

Weiterhin sind Mischungen von Polymeren mit Additiven denkbar, die sich beim Formungsprozeß so ausrichten, daß an der Oberfläche hydrophobe Gruppen vorherrschen. Als Additiv kommen fluorierte Wachse, z. B. die Hostaflone der Hoechst AG in Frage.

Die Strukturierung der Oberfläche kann nach der hydrophoben Beschichtung eines Werkstoffs durchgeführt werden.

Die chemischen Modifikationen können auch nach der Formgebung durchgeführt werden, so daß die Erhebungen nachträglich mit einem Material mit einer Oberflächenenergie von 10 bis 20 mN/m ausgestattet werden können.

Da insbesondere die chemischen Eigenschaften der obersten Monolage des Materials für den Randwinkel entscheidend sind, kann gegebenenfalls eine Oberflächenmodifikation mit Verbindungen, die hydrophobe Gruppen enthalten, erfolgen. Verfahren dieser Art beinhalten die kovalente Anbindung von Monomeren oder Oligomeren an die Oberfläche durch eine chemische Reaktion, so z. B. Behandlungen mit Alkylfluorsilanen wie Dynasilan F 8261 der Sivento Chemie Rheinfelden GmbH oder mit fluorierten Ormoceren.

Weiterhin sind Verfahren, bei denen zunächst Radikalstellen auf der Oberfläche erzeugt werden, die bei An- oder Abwesenheit von Sauerstoff mit radikalisch polymerisierbaren Monomeren abreagieren, zu nennen. Die Aktivierung der Oberflächen kann mittels Plasma, UV- oder γ-Strahlung, sowie speziellen Photoinitiatoren erfolgen. Nach der Aktivierung der Oberfläche, d. h. Erzeugung von freien Radikalen können die Monomeren aufpolymerisiert werden. Ein solches Verfahren generiert eine mechanisch besonders widerstandsfähige Beschichtung.

Die Beschichtung eines Werkstoffs oder einer strukturierten Oberfläche durch Plasmapolymerisation von Fluoralkenen oder ganz oder teilweise fluorierten Vinylverbindungen hat sich besonders bewährt.

Die Hydrophobierung einer strukturierten Oberfläche mittels einer HF-Hohlkathoden-Plasmaquelle mit Argon als Trägergas und C₄F₈ als Monomer bei einem Druck von ca. 0.2 mbar stellt eine technisch einfache und elegante Variante zur nachträglichen Beschichtung dar.

Außerdem kann ein bereits gefertigter Gegenstand mit einer dünnen Schicht eines hydrophoben Polymeren überzogen werden. Dies kann in Form eines Lackes oder durch Polymerisation von entsprechenden Monomeren auf der Oberfläche des Gegenstandes erfolgen. Als polymerer Lack können Lösungen oder Dispersionen von Polymeren wie z. B. Polyvinylidenfluorid (PVDF) oder Reaktivlacke zum Einsatz kommen.

Als Monomere für eine Polymerisation auf den Werkstoffen oder deren strukturierten Oberflächen kommen insbesondere Alkylfluorsilane wie Dynasilan F 8261 (Sivento Chemie Rheinfelden GmbH, Rheinfelden) in Frage.

Die Formgebung oder Strukturierung der Oberflächen kann durch Prägen/Walzen oder gleichzeitig beim makroskopischen Formen des Gegenstandes wie z. B. Gießen, Spritzgießen oder andere formgebende Verfahren erfolgen. Hierzu sind entsprechende Negativformen der erwünschten Struktur erforderlich.

Negativformen lassen sich industriell z. B. mittels der Liga-Technik (R. Wechsung in Mikroelektronik 9, (1995) S. 34 ff) herstellen. Hier wird zunächst eine oder mehrere Masken durch Elektronenstrahllithographie nach den Dimensionen der gewünschten Erhebungen hergestellt. Diese Masken dienen zur Belichtung einer Photoresistschicht durch Röntgentiefenlithographie, wodurch eine Positivform erhalten wird. Die Zwischenräume im Photoresist werden anschließend durch galvanische Abscheidung eines Metalls aufgefüllt. Die so erhaltene Metallstruktur stellt eine Negativform für die gewünschte Struktur dar.

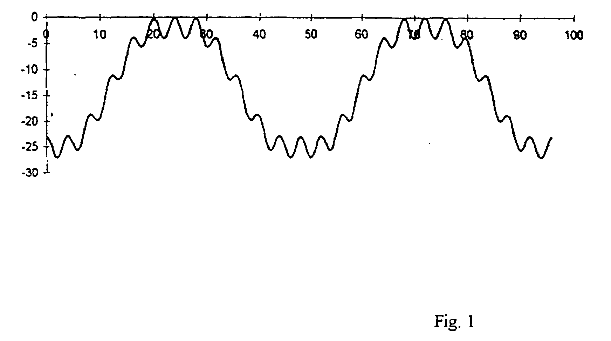

In einer anderen Ausführungsform der vorliegenden Erfindung sind die Erhebungen auf einer etwas groberen Überstruktur angeordnet (Fig. 1).

Die Erhebungen weisen die oben ausgeführten Dimensionen auf und können auf einer Überstruktur mit einer mittleren Höhe von 10 µm bis 1 mm und einem mittleren Abstand von 10 µm bis 1 mm aufgebracht werden.

Die Erhebungen und die Überstruktur können gleichzeitig oder nacheinander mechanisch eingeprägt, durch lithographische Verfahren oder durch formgebende Verarbeitung aufgebracht werden.

Eine solche "doppelte" Strukturierung hat sich besonders bei groben Verschmutzungen bewährt und weist gegenüber der "einfachen" Mikrostrukturierung eine erhöhte mechanische Belastbarkeit auf.

Die Erhebungen und die Überstruktur können eine periodische Anordnung besitzen. Es sind jedoch auch stochastische Verteilungen der Dimensionen der Überstruktur und der Erhebungen, gleichzeitig oder unabhängig voneinander, zulässig.

Die Formgebung bzw. -strukturierung der Oberflächen erfolgt bei Oberflächen mit Überstruktur wie bei Oberflächen nur mit Mikrostruktur, zweckmäßig in einem Arbeitsgang. Eine nachträgliche Hydrophobierung bzw. chemische Modifikation einer bereits erzeugten "doppelt" strukturierten Oberfläche ist selbstverständlich ebenso möglich.

Erfindungsgemäß hergestellte Oberflächen sind ab einer Strukturierung kleiner 400 nm transparent und eignen sich daher für alle Anwendungen, bei denen es auf eine hohe Transmission oder gute optische Eigenschaften ankommt. Hier ist besonders die Herstellung oder Beschichtung von Scheinwerfern, Windschutzscheiben, Werbeflächen oder Abdeckungen von Solarzellen (photovoltaisch und thermisch) zu nennen.

Ein weiteres Anwendungsgebiet für die erfindungsgemäßen Oberflächen sind rückstandsfrei zu entleerende Behälter oder schnell zu reinigende Halterungen wie zum Beispiel Waferhalterungen in der Halbleiterproduktion. Wafer werden innerhalb ihres Herstellungsprozesses mit speziellen Halterungen (Cassetten) in verschiedene Bäder transportiert. Um ein Weitertragen der verschiedenen Badflüssigkeiten zu vermeiden, sind Reinigungsschritte, insbesondere der Halterungen, erforderlich. Die Reinigungs- oder Trocknungsschritte entfallen, wenn die jeweilige Badflüssigkeit beim Entfernen des Wafers aus dem Bad von der Halterung restlos abtropft.

Erfindungsgemäße Oberflächen eignen sich daher hervorragend zur Herstellung von Erzeugnissen, deren Oberfläche das Ablaufen von Flüssigkeiten begünstigt. Bevorzugt werden erfindungsgemäße Oberflächen zur Herstellung von Erzeugnissen verwendet, die sich durch ablaufendes Wasser selbst reinigen. Bevorzugte Erzeugnisse sind Behälter, transparente Körper oder Halterungen.

Das nachfolgende Beispiel soll die vorliegende Erfindung näher beschreiben, ohne ihren Umfang zu beschränken.

### Beispiel

Es wurde eine Negativform durch UV-Litographie eines photoempfindlichen Kunststoffs und anschließender Galvanoformung mit Nickel hergestellt. Mit dieser Form konnte eine Polycarbonatfolie mit einer Mikrostruktur mit Erhebungen von ca. 2 µm Breite (gemessen auf halber Höhe) und ca. 4 µm Höhe bei einem Abstand von 4 µm gegossen werden. Diese Erhebungen sind auf einer Überstruktur mit einer Höhe von ca. 23 µm und einem Abstand von ca. 48 µm angeordnet. Die Struktur der Form besitzt die gleichen Dimensionen mit umgekehrtem Vorzeichen. Fig. 1 zeigt einen schematischen Querschnitt (Abszizze und Ordinate in [µm]).

Die so strukturierte Polycarbonatfolie wurde anschließend mit Dynasilan F 8261 (Sivento Chemie Rheinfelden GmbH, Rheinfelden) hydrophobiert.

Eine ebenso hydrophobierte, jedoch unstrukturierte Folie wies einen Randwinkel mit Wasser von 109.8 + 0.4 ° und eine Oberflächenenergie kleiner 20 mN/m (bestimmt nach Owens et al.) die strukturierte Folie einen Randwinkel von 150 ° auf. Auch hartnäckige Verschmutzungen mit öligen Substanzen konnten durch einfaches Abspülen mit Wasser entfernt werden.

## Patentansprüche

1. Strukturierte Oberflächen,
**dadurch gekennzeichnet,**
**dass** sie Erhebungen mit einer mittleren Höhe von 50 nm bis 10 µm und einem mittleren Abstand von 50 nm bis 4 µm sowie Oberflächenenergien des unstrukturierten Materials von 10 bis 20 mN/m aufweisen.

2. Strukturierte Oberflächen nach Anspruch 1,
**dadurch gekennzeichnet,**
**dass** die Erhebungen eine mittlere Höhe von 50 nm bis 4 µm aufweisen.

3. Strukturierte Oberflächen nach Anspruch 1,
**dadurch gekennzeichnet,**
**dass** die Erhebungen eine mittlere Höhe von 50 nm bis 4 µm und einen mittleren Abstand von 50 nm bis 4 µm aufweisen.

4. Strukturierte Oberflächen nach Anspruch 1,
**dadurch gekennzeichnet,**
**dass** die Erhebungen ein Aspektverhältnis von 0,5 bis 20 aufweisen.

5. Strukturierte Oberflächen nach Anspruch 4,
**dadurch gekennzeichnet,**
**dass** die Erhebungen ein Aspektverhältnis von 1 bis 10 aufweisen.

6. Strukturierte Oberflächen nach Anspruch 4,
**dadurch gekennzeichnet,**
**dass** die Erhebungen ein Aspektverhältnis von 1 bis 3.0 aufweisen.

7. Strukturierte Oberflächen nach einem der Ansprüche 1 bis 6,
**dadurch gekennzeichnet,**
**dass** die Erhebungen auf einer Überstruktur mit einer mittleren Höhe von 10 µm bis 1 mm und einem mittleren Abstand von 10 µm bis 1 mm aufgebracht sind.

8. Verfahren zur Herstellung von strukturierten Oberflächen gemäß einem der Ansprüche 1 bis 7,
**dadurch gekennzeichnet,**
**dass** die Erhebungen auf einen Werkstoff mit einer Oberflächenenergie von 10 bis 20 mN/m mechanisch eingeprägt oder durch lithographische Verfahren eingeätzt oder durch formgebende Verarbeitung aufgebracht werden.

9. Verfahren nach Anspruch 8,
**dadurch gekennzeichnet,**
**dass** die Erhebungen und die Überstruktur gleichzeitig oder nacheinander mechanisch eingeprägt, durch lithographische Verfahren eingeätzt oder durch formgebende Verarbeitung aufgebracht werden.

10. Verfahren nach einem der Ansprüche 8 oder 9,
**dadurch gekennzeichnet,**
**dass** die Erhebungen nachträglich mit einem Material mit einer Oberflächenenergie von 10 bis 20 mN/m ausgestattet werden.

11. Verfahren nach einem der Ansprüche 8 bis 10,
**dadurch gekennzeichnet,**
**dass** der Werkstoff Polytetrafluorethylen, Polyvinylidenfluorid oder Polymere aus Perfluoralkoxyverbindungen beinhaltet.

12. Verfahren nach einem der Ansprüche 8 bis 10,
**dadurch gekennzeichnet,**
**dass** der Werkstoff oder die strukturierten Oberflächen mit Alkylfluorsilanen behandelt werden.

13. Verfahren nach einem der Ansprüche 8 bis 10,
**dadurch gekennzeichnet,**
**dass** der Werkstoff oder die strukturierten Oberflächen durch Plasmapolymerisation von Fluoralkenen oder ganz oder teilweise fluorierten Vinylverbindungen beschichtet werden.

14. Verwendung der strukturierten Oberflächen gemäß einem der Ansprüche 1 bis 7 zur Herstellung von mit polaren oder unpolaren Flüssigkeiten nicht oder nur schwer benetzbaren Erzeugnissen.

15. Verwendung der strukturierten Oberflächen gemäß Anspruch 14,
wobei die Oberfläche der Erzeugnisse das Ablaufen von Flüssigkeiten begünstigt.

16. Verwendung der strukturierten Oberflächen nach Anspruch 14,
wobei sich die Erzeugnisse durch ablaufendes Wasser selbst reinigen.

17. Verwendung der strukturierten Oberflächen nach Anspruch 14,
wobei die Erzeugnisse Behälter, transparente Körper oder Halterungen sind.

## Claims

1. A structured surface, **characterized in that** it has protuberances having an average height of 50 nm to 10 µm and an average spacing of 50 nm to 4 µm and surface energies of the unstructured material of 10 to 20 mN/m.

2. A structured surface according to claim 1, wherein the protuberances have an average height of 50 nm to 4 µm.

3. A structured surface according to claim 1, **characterized in that** the protuberances have an average height of 50 nm to 4 µm and an average spacing of 50 nm to 4 µm.

4. A structured surface according to claim 1, **characterized in that** the protuberances have an aspect ratio of from 0.5 to 20.

5. A structured surface according to claim 4, **characterized in that** the protuberances have an aspect ratio of from 1 to 10.

6. A structured surface according to claim 4, **characterized in that** the protuberances have an aspect ratio of from 1 to 3.0.

7. A structured surface according to any one of claims 1 to 6, **characterized in that** the protuberances are applied to a superstructure having an average height of 10 µm to 1 mm and an average spacing of 10 µm to 1 mm.

8. A process for the production of structured surfaces according to any one of claims 1 to 7, **characterized in that** the protuberances are formed on a material having a surface energy of 10 to 20 mN/m by mechanical impression or are etched by lithographic methods or are applied by shaping.

9. A process according to claim 8, **characterized in that** the protuberances and the superstructure are formed by mechanical impression simultaneously or in succession, are etched by lithographic methods or are applied by shaping.

10. A process according to either one of claims 8 and 9, **characterized in that** the protuberances are subsequently provided with a material having a surface energy of 10 to 20 mN/m.

11. A process according to any one of claims 8 to 10, **characterized in that** the material contains polytetrafluoroethylene, polyvinylidene fluoride or polymers of perfluoroalkoxy compounds.

12. A process according to any one of claims 8 to 10, **characterized in that** the material or the structured surfaces is or are treated with alkylfluorosilanes.

13. A process according to any one of claims 8 to 10, **characterized in that** the material or the structured surfaces is or are coated by plasma polymerization of fluoroalkenes or perfluorinated or partially fluorinated vinyl compounds.

14. The use of the structured surfaces according to any one of claims 1 to 7 for the production of products which cannot be wet or can be wet only with difficulty with polar or nonpolar liquids.

15. The use of the structured surfaces according to claim 14, the surface of the products promoting the running off of liquids.

16. The use of the structured surfaces according to claim 14, the products being self-cleaning as a result of water running off.

17. The use of the structured surfaces according to claim 14, the products being containers, transparent bodies or holders.

## Revendications

1. Surfaces structurées,
**caractérisées en ce qu'**
elles possèdent des bosses ayant une hauteur moyenne de 50 nm à 10 µm et une distance moyenne de 50 nm à 4 µm ainsi que des énergies de surface du matériau non structurée de 10 à 20 mN/m;

2. Surfaces structurées selon la revendication 1
**caractérisées en ce que**
les bosses possèdent une hauteur moyenne de 50 nm à 4 µm.

3. Surfaces structurées selon la revendication 1,
**caractérisées en ce que**
les bosses possèdent une hauteur moyenne de 50 nm à 4 µm et une distance moyenne de 50 nm à 4 µm.

4. Surfaces structurées selon la revendication 1,
**caractérisées en ce que**
les bosses possèdent un rapport d'aspect de 0,5 à 20.

5. Surfaces structurées selon la revendication 4,
**caractérisées en ce que**
les bosses possèdent un rapport d'aspect de 1 à 10.

6. Surfaces structurées selon la revendication 4,
**caractérisées en ce que**
les bosses possèdent un rapport d'aspect de 1 à 3,0.

7. Surfaces structurées selon l'une des revendications 1 à 6,
**caractérisées en ce que**
les bosses sont appliquées sur une sur structure ayant une hauteur moyenne de 10 µm à 1 mm et un intervalle de 10 µm à 1 mm.

8. Procédé de préparation de surfaces structurées selon l'une des revendications 1 à 7,
**caractérisé en ce que**
les bosses sont imprimées mécaniquement sur un matériau ayant une énergie de surface de 10 à 20 mN/m, ou sont introduites par corrosion par un procédé de lithographique ou sont appliquées par un façonnage de modelage.

9. Procédé selon la revendication 8,
**caractérisé en ce que**
les bosses et la superstructure en même temps ou l'une après l'autre sont imprimées mécaniquement, ou sont introduites par corrosion par un procédé de lithographique ou sont appliquées par un façonnage de modelage.

10. Procédé selon l'une des revendications 8 ou 9,
**caractérisé en ce que**
les bosses sont formées intérieurement d'un matériau ayant une énergie de surface de 10 à 20 mN/m.

11. Procédé selon l'une des revendications 8 à 10,
**caractérisé en ce que**
le matériau incorpore du polytétrafluoréthylène, du fluorvre de polyvinylidène ou des polymères à base de composés perfluoroalkoxyles.

12. Procédé selon l'une des revendications 8 à 10,
**caractérisé en ce que**
le matériau ou les surfaces structurées est traité avec des alkylfluorosilanes.

13. Procédé selon l'une des revendications 8 à 10,
caractérlsé en ce que
le matériau ou les surfaces structurées sont revêtus par polymérisation par plasma de fluoroalcènes ou de composés vinyliques totalement ou partiellement fluorés.

14. Utilisation des surfaces structurées conformément à l'une des revendications 1 à 7,
en vue de la production de produits non mouillables ou seulement difficilement mouillables.

15. Utilisation des surfaces structurées conformément à la revendication 14,
dans laquelle la surface des produits favorise l'écoulement des liquides.

16. Utilisation des surfaces structurées selon la revendication 14,
dans laquelle les produits se nettoient eux-mêmes grâce à l'eau qui s'écoule.

17. Utilisation des surfaces structurées selon la revendication 14,
dans laquelle les produits sont des récipients, des solides transparents ou des fixations.
